# DEMANDE DE BREVET EUROPEEN

(11) **EP 1 276 126 A1**
(43) Date de publication de la demande: **15.01.2003**
(21) Numéro de dépôt: 02356116.0
(22) Date de dépôt: 24.06.2002
(51) Int. Cl.: H01H 50/00

(54) **Composant microélectromécanique**

(30) Priorité: 02.07.2001 FR 0108743
(71) Demandeur: Memscap, 38330 Saint Ismier (FR)
(72) Inventeur: Mhani, Ahmed, 38100 Grenoble (FR); Fedeli, Jean-Marc, 38120 Saint Egreve (FR)
(74) Mandataire: Palix, Stéphane

(57) **Abrégé**

Composant microélectromécanique (1) assurant des fonctions de filtrage, réalisé sur un substrat à base de matériau semi-conducteur, et comportant deux bornes d'entrée et deux bornes de sortie, **caractérisé** en ce qu'il comporte également :
· un équipage mobile (4) relié au substrat par au moins une portion déformable, et incluant une région réalisée en un matériau ferromagnétique ;
· un bobinage métallique (5) relié aux bornes d'entrée ou de sortie (30, 31), apte à interagir magnétiquement avec la région en matériau ferromagnétique de l'équipage mobile (4) ;
· une surface formant une première électrode (6), reliée à une des bornes de sortie ou d'entrée, disposée en regard d'une surface complémentaire solidaire de l'équipage mobile (4), cette surface complémentaire formant une seconde électrode reliée à l'autre des bornes de sortie ou d'entrée, et étant apte à interagir électrostatiquement avec la première électrode (6).

## Description

### Domaine technique

L'invention se rattache au domaine de la microélectronique, et plus précisément à celui des composants utilisés dans les gammes radiofréquences. Elle vise plus spécifiquement une nouvelle structure de filtres passifs utilisés dans les circuits électroniques, et réalisée à partir de systèmes microélectromécaniques connus sous l'appellation anglaise de "MEMS" pour "micro electromechanical systems".

### Techniques antérieures

Dans le domaine des télécommunications, divers types de filtres sont utilisés pour réaliser les fonctions de filtrage, notamment dans les étages de fonctionnant à la fréquence intermédiaire, ou dans des oscillateurs, ou bien encore dans d'autres types de fonction.

Parmi les différents filtres utilisés, on peut notamment citer les filtres à quartz, ainsi que les filtres à ondes sonores de surface, également connues sous l'abréviation "SAW" pour *"surface acoustic wave".* Ce type de filtre fonctionne en utilisant des phénomènes piézoélectriques. Ils sont appréciés pour leur fort coefficient de qualité, ainsi qu'une excellente stabilité, notamment de la fréquence de résonance vis à vis de la température et du vieillissement. Cependant, à cause de limitations technologiques, il est impossible d'augmenter de façon très importante le nombre de pôles d'un tel filtre. Ces mêmes contraintes technologiques rendent ce type de filtre très difficile à miniaturiser fortement.

On a également proposé de réaliser des filtres en technologies MEMS, qui fonctionnent sur la base de phénomènes électrostatiques.

Ainsi, de façon générale, un tel filtre utilise deux armatures fonctionnant à la manière d'un condensateur.

L'application d'une tension alternative fonction du signal d'entrée aux bornes de ce condensateur induit un déplacement de l'armature qui est mobile, et donc une variation de la capacité du condensateur, et par conséquent la variation d'un signal de sortie. Les deux armatures sont mobiles l'une par rapport à l'autre, et une partie du système agit comme organe de rappel pour s'opposer à la déformation générée par la variation du signal d'entrée. La fréquence propre de ce filtre est fonction de la géométrie de la structure, ainsi que de la tension de polarisation appliquée entre les armatures.

Plusieurs géométries ont déjà été envisagées pour des filtres fonctionnant uniquement à base de phénomènes électrostatiques.

Ainsi, il existe des filtres ou plus généralement des résonateurs dans lesquels l'armature mobile se déplace perpendiculairement au plan principal du substrat sur lequel est réalisé le microcomposant. Certains de ces résonateurs peuvent d'ailleurs être couplés entre eux pour assurer une meilleure performance. Un des inconvénients de ce type de résonateur est une certaine sensibilité aux variations de pression, qui nécessitent l'encapsulation des microcomposants sous vide ou sous très faible pression.

On connaît par ailleurs, d'autres filtres fonctionnant à base de phénomènes électrostatiques, et dans lesquels l'armature mobile se déplace dans un plan parallèle au plan principal du substrat sur lequel est réalisé le microcomposant. Il en va ainsi pour les filtres dont les armatures sont formées par des peignes interdigités. Grâce à cette configuration, les surfaces en regard des autres armatures sont relativement importantes, ce qui permet d'obtenir des courses suffisantes avec des tensions de polarisation moins élevées que pour les solutions décrites ci-avant.

Néanmoins, ces solutions présentent certaines limitations. En effet, la fréquence propre d'un tel résonateur est fonction de la constance de raideur des moyens de rappel interposés entre les armatures, ainsi que de la masse de l'armature mobile. Ainsi, pour atteindre des fréquences de résonance élevées, il sera préférable d'augmenter la constante de raideur tout en diminuant la masse de l'armature mobile. Toutefois, l'emploi d'une constante de raideur élevée se traduit par une faible amplitude de déplacement de l'armature mobile, qui n'est pas toujours suffisante pour bien distinguer le signal généré du bruit. Un compromis reste donc à faire entre l'augmentation de la fréquence du filtre et l'amplitude du signal de sortie.

Un premier problème que se propose donc de résoudre l'invention est celui de l'augmentation des fréquences de résonance des filtres réalisés selon les technologies MEMS. Un autre problème que se propose de résoudre l'invention est celui de la nécessité de réaliser des packagings sous vide pour conserver une bonne stabilité du filtre et une fréquence de résonance élevée.

Un autre problème est celui de la compatibilité entre l'augmentation de la fréquence de résonance et le niveau de signal de sortie, observé sur les filtres en technologie MEMS, fonctionnant à base de phénomènes électrostatiques. Un autre problème que cherche à résoudre l'invention est celui de l'emploi de tensions de polarisation élevées qui engendrent des consommations relativement importantes, au détriment de l'autonomie, et qui induisent des contraintes d'isolation.

### Exposé de l'invention

L'invention concerne donc un microcomposant électromécanique, assurant des fonctions de filtrage, réalisé sur un substrat à base de matériau semi-conducteur, et comportant deux bornes d'entrée, deux bornes de sortie.

Conformément à l'invention, ce microcomposant comporte également :
◆ un équipage mobile relié au substrat par au moins une portion déformable, et incluant une région réalisée en un matériau ferromagnétique ;
◆ un bobinage métallique relié aux bornes d'entrée ou de sortie, apte à interagir magnétiquement avec la région en matériau ferromagnétique de l'équipage mobile ;
◆ une surface formant une première électrode, reliée à une des bornes de sortie ou d'entrée, disposée en regard d'une surface complémentaire solidaire de l'équipage mobile, cette surface complémentaire formant une seconde électrode reliée à l'autre des bornes de sortie ou d'entrée, et étant apte à interagir électrostatiquement avec la première électrode.

Autrement dit, le filtre fonctionne en combinant deux conversions d'énergie de nature différente. L'équipage mobile peut être mis en mouvement sous l'effet d'un champ magnétique, de sorte qu'une énergie électrique est transformée en énergie magnétique. Cette énergie magnétique se matérialise au niveau de l'équipage mobile par une énergie cinétique qui peut à son tour être transformée en énergie électrique par des phénomènes du type électrostatique. La combinaison inverse des deux conversions d'énergie peut également avoir lieu, c'est-à-dire que l'équipage mobile peut être mis en mouvement sous l'effet de phénomènes électrostatiques, cette énergie cinétique étant ensuite convertie en énergie électrique par l'intermédiaire d'une interaction de nature magnétique.

En employant une conversion d'énergie électrique en énergie magnétique et vice versa, on améliore la sensibilité du filtre à des fréquences plus élevées en comparaison avec des filtres fonctionnant uniquement sur des principes électrostatiques. En effet, on parvient à augmenter la fréquence de résonance en choisissant un rapport de la raideur des moyens de rappel sur la masse de l'équipage mobile qui est important. Bien que les amplitudes des oscillations mécaniques soient relativement faibles, on obtient toutefois un signal généré au niveau de l'étage de sortie qui est suffisamment important pour pouvoir être exploitable.

Plus précisément, dans un premier cas de figure, le bobinage métallique est relié aux bornes d'entrée, et est apte à générer un champ magnétique lorsqu'il est parcouru par un courant. L'équipage mobile est quant à lui apte à se déplacer sous l'effet de la force subie par la région en matériau ferromagnétique, qui est engendrée par le champ magnétique généré par le bobinage d'entrée. Ce déplacement provoque une variation de la capacité mesurée entre les deux électrodes reliées aux bornes de sortie. Cette variation de capacité peut être détectée par un dispositif approprié, et correspond au filtrage souhaité du signal correspondant au courant injecté dans le bobinage d'entrée.

A l'inverse, dans un autre cas de figure, les électrodes électrostatiques sont reliées aux bornes d'entrée, et elles sont aptes à se déplacer l'une par rapport à l'autre lorsqu'une différence de potentiel leur est appliquée. Ce déplacement engendre un déplacement de la région en matériau ferromagnétique de l'équipage mobile par rapport au bobinage métallique.

Si l'équipage mobile est en matériau ferromagnétique dur, et forme un aimant permanent, le déplacement de l'équipage mobile induit une variation du flux magnétique à l'intérieur de ce bobinage de sortie, et donc la génération d'une force contre électromotrice aux bornes du bobinage métallique.

Lorsque le matériau utilisé sur l'équipage mobile est un matériau ferromagnétique doux, son déplacement modifie le circuit magnétique du bobinage de sortie, ce qui se traduit par une variation du coefficient d'inductance du bobinage de sortie. Cette variation d'inductance peut être détectée par tout dispositif approprié.

Le matériau ferromagnétique utilisé sur l'équipage mobile peut être soit ferromagnétique doux, soit ferromagnétique dur, ce dernier reste pourtant préférable puisqu'il permet de générer plus de force.

Différentes formes et architectures peuvent être employées tant pour les bobinages métalliques que pour la zone comportant les électrodes.

Ainsi, le bobinage métallique peut être du type solénoïde ou bien encore de type plan en spirale, dans le premier cas, le champ magnétique généré est sensiblement parallèle au plan principal du substrat. Le déplacement de l'équipage mobile s'effectue alors également selon le plan principal du substrat.

Dans ce cas, la paire d'électrodes peut par exemple être constituée par un système de peignes interdigités, fonctionnant également par un déplacement dans une direction parallèle au plan principal du substrat.

Dans le cas où le bobinage métallique est de type bobinage plan en spirale, il peut par exemple être réalisé selon le plan principal du substrat, et générer un champ magnétique qui est perpendiculaire au plan du substrat, au niveau du centre du bobinage, avec des lignes de champ se refermant dans des plans perpendiculaires au plan principal du substrat, à l'extérieur du bobinage. Dans ce cas, chacune des électrodes, à savoir l'électrode fixe et l'électrode mobile peuvent présenter une configuration sensiblement parallèle au plan principal du substrat, et se déplacer l'une par rapport à l'autre perpendiculairement à ce même plan.

Diverses architectures peuvent être employées en ce qui concerne l'équipage mobile. Ainsi, ce dernier peut être relié au substrat par une seule portion déformable. Il peut être également relié au substrat par deux ou voire plus portions déformables, situées de part et d'autre de l'équipage mobile. La forme et les dimensions de ces portions déformables sont déterminées pour que les moyens de rappel présentent la raideur optimale, ainsi qu'une amplitude de mouvement suffisante et une solidité adéquate.

En pratique, ce composant peut être intégré dans un filtre à un ou plusieurs pôles, en association avec un ou plusieurs composants du même type ou de type différent.

### Description sommaire des figures

La manière de réaliser l'invention ainsi que les avantages qui en découlent ressortiront bien de la description des deux modes de réalisation qui suivent, à l'appui des figures annexées dans lesquelles :
La figure 1 est une vue en perspective sommaire d'un composant conforme à l'invention, et réalisée selon un premier mode d'exécution.
La figure 2 est une vue de dessus du composant de la figure 1.
La figure 3 est une vue en perspective sommaire d'un composant conforme à 5 l'invention, réalisée selon un seconde mode d'exécution.
La figure 4 est une vue en coupe transversale, selon le plan IV-IV' de la figure 3.

### Manière de réaliser l'invention

Comme évoqué ci-avant, l'invention concerne un microcomposant qui est utilisé dans un filtre à un ou plusieurs pôles. Ce microcomposant fonctionne sur le principe d'une conversion d'énergie électrique en une énergie cinétique, par l'intermédiaire de phénomènes de nature soit électrostatique, soit magnétostatique, puis la conversion de cette énergie cinétique en énergie électrique par l'intermédiaire de phénomènes soit magnétostatiques, soit électrostatiques.

L'invention peut être mise en oeuvre en employant différentes architectures permettant d'obtenir des résultats analogues et fonctionnant sur des principes équivalents.

### Première manière de réaliser l'invention

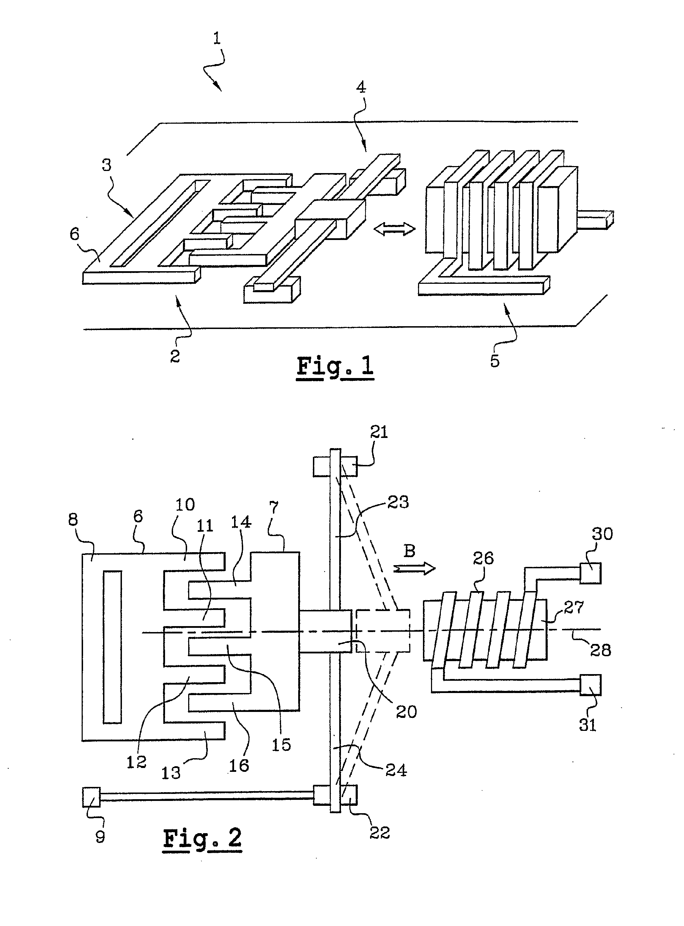

Comme illustré aux figures 1 et 2, le microcomposant (1) peut être réalisé sur une couche de substrat (2) à base de matériau semi-conducteur, tel que du polysilicium.

Ce composant (1) comprend de façon principale un étage d'entrée (3), un équipage mobile (4), et un bobinage de sortie (5).

Plus précisément, l'étage d'entrée (3) est réalisé sous la forme d'une paire de peignes interdigités (6, 7). Un de ces peignes (6) est fixe par rapport au substrat (2), et est relié à une des bornes (8) d'entrée du filtre. Ce peigne (6) comporte une pluralité de dents (10-13) dirigées en direction de l'équipage mobile (4), et réalisées dans le plan principal du substrat (2). Bien entendu, l'invention n'est pas limitée à la seule forme illustrée, qui ne comprend qu'un nombre de dents limitées, pour des raisons de simplification, mais couvre bien au contraire toutes les variantes fonctionnant sur le même principe.

Cette électrode fixe (6) peut être réalisée en un matériau métallique, et selon un procédé classique.

L'étage d'entrée (3) comprend également une armature mobile, formée également d'un peigne (7) comportant une pluralité de dents (14-16). Ces différentes dents (14-16) sont intercalées entre les dents (10-13) de l'armature fixe (6). Les dimensions des différentes dents, ainsi que de la profondeur d'interpénétration sont déterminées par rapport à l'amplitude souhaitée du mouvement de l'équipage mobile (4).

L'armature mobile (7) est solidaire de l'équipage mobile (4), et plus précisément dans la forme illustrée aux figures 1 et 2, d'une région ou plot (20) en un matériau ferromagnétique. Ce plot (20) en matériau ferromagnétique est relié à deux points fixes (21, 22) par rapport au substrat, par l'intermédiaire de deux poutres transversales flexibles (23, 24). La longueur et les dimensions en section de ces poutres (23, 24) sont déterminées de telle manière à ce que la raideur correspondante soit maximale dans la direction perpendiculaire au plan du substrat, et corresponde à la valeur souhaitée dans le sens de déplacement du plot (20) correspondant à la direction de déplacement de l'armature mobile (7).

L'armature mobile (7) est électriquement reliée à la seconde borne d'entrée (9) par l'intermédiaire des plots fixes (21, 22) et des poutres (23,24) ainsi que le plot en matériau ferromagnétique (20).

De l'autre côté de l'équipage mobile (4) par rapport aux peignes interdigités (6, 7), le microcomposant comporte un bobinage métallique (5), réalisé sous forme d'un solénoïde.

Ce solénoïde (5) comprend différentes spires métalliques (26) enroulées autour d'un noyau magnétique (27). Ce solénoïde (5) peut par exemple être réalisé selon le procédé décrit dans le document EP 1 054 417 du Demandeur. I1 peut toutefois être réalisé selon un procédé différent. L'axe (27) de ce solénoïde (5) passe par le centre du plot (20) en matériau ferromagnétique, et il est aligné avec la direction de déplacement de l'armature mobile. L'enroulement du solénoïde (5) est relié aux bornes de sortie (30, 31) du filtre.

Le fonctionnement du dispositif est le suivant: lorsqu'une tension est appliquée entre les bornes d'entrée (8, 9) du filtre, des forces de nature électrostatique apparaissent entre les différentes dents (10-16) de l'armature fixe (6) et de l'armature mobile (7). Cette tension comporte une composante quasi continue assurant une polarisation de l'ensemble, ainsi qu'une composante alternative, constituant le signal à filtrer.

En fonction de cette tension de polarisation, du signal à filtrer, ainsi que de la géométrie des deux armatures, l'armature mobile (7) se déplace à la fréquence du signal à filtrer dans la tension d'entrée. Ce déplacement est illustré de façon schématique à la figure 2, qui montre en pointillés l'équipage mobile (7) dans une position éloignée de la position de repos.

Lorsque le matériau choisi pour réaliser le plot ferromagnétique (20) est un matériau ferromagnétique dur, c'est-à-dire présentant une aimantation permanente, il génère un champ magnétique qui est orienté selon l'axe (28) du solénoïde (5). Le déplacement du plot (20) induit une variation du flux de ce champ magnétique B à l'intérieur du solénoïde (5). Cette variation de flux se traduit par l'apparition d'une force contre électromotrice contre les deux bornes de sortie (30, 31) du filtre.

Lorsque le matériau utilisé pour former le plot ferromagnétique (20) est un matériau ferromagnétique doux, son déplacement parallèlement à l'axe (28) du solénoïde (5), modifie la configuration du circuit magnétique de ce dernier. Cette variation se traduit par une modification du coefficient d'inductance du solénoïde (5). Cette variation peut être analysée par un dispositif approprié, ou bien encore induire une modification dans un circuit dans lequel ce solénoïde est intégré.

Le composant décrit ci-avant peut également fonctionner d'une manière différente, de manière à filtrer un signal injecté sur le solénoïde (5). Dans ce cas, lorsque un courant parcourt le solénoïde (5), le champ magnétique généré par ce dernier attire ou repousse le plot (20) en matériau ferromagnétique de l'équipage mobile (4). Il s'ensuit que l'armature mobile (7) se déplace par rapport à l'armature fixe (6), et que donc la capacité mesurée entre l'armature fixe (6) et l'armature mobile (7) varie. Cette variation, qui constitue un signal de nature électrique, peut être analysée par un dispositif approprié ou être utilisé dans un circuit dans lequel cette capacité est intégrée.

### Deuxième manière de réaliser l'invention

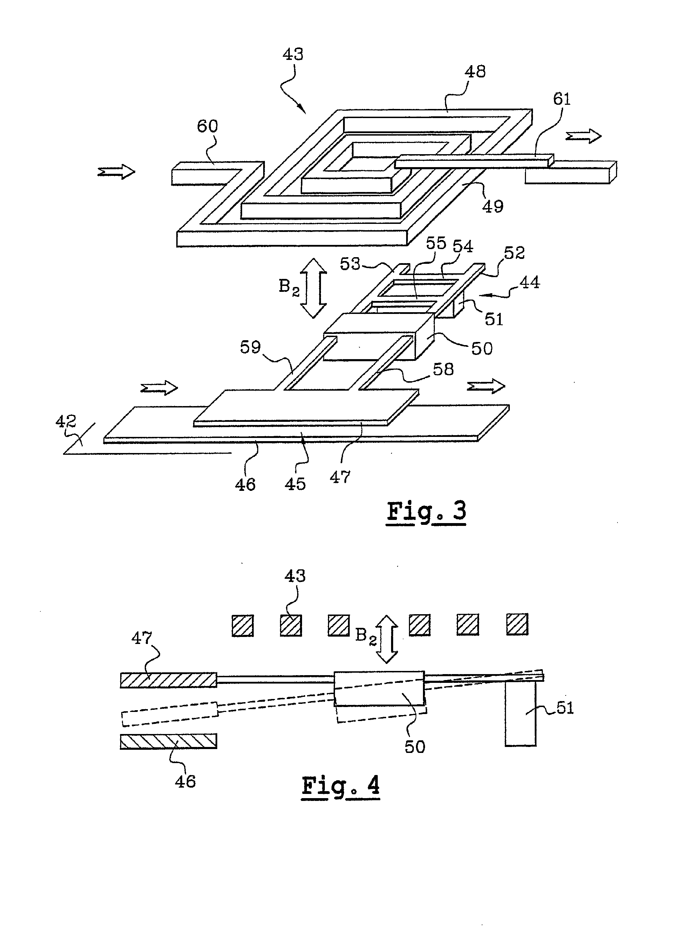

Les figures 3 et 4 illustrent un autre mode de réalisation de l'invention qui fonctionne sur des principes analogues que le premier exemple décrit ci-avant, mais qui adopte une géométrie différente.

Plus précisément, ce composant (40) comprend un bobinage métallique d'entrée (43), un équipage mobile (44) et une paire d'armatures (46, 47) formant capacité variable, correspondant à l'étage de sortie (45).

Le bobinage d'entrée (43) est réalisé sous forme d'un enroulement plan en spirale, parallèle au plan principal (42) du substrat. Cet enroulement (43) possède plusieurs segments parallèles et perpendiculaires (48, 49), qui peuvent être réalisés en particulier selon les enseignements du document EP 1 039 544 du Demandeur. Néanmoins, d'autres procédés peuvent être utilisés pour réaliser de tels enroulements.

Lorsque le bobinage d'entrée (43) est parcouru par un courant électrique, un champ magnétique B₂ est généré, perpendiculairement au plan de l'enroulement (43), au niveau de la zone centrale de ce dernier.

A l'aplomb du centre de l'enroulement (43), se trouve un plot (50) en un matériau ferromagnétique qui est relié à un point fixe (51) par rapport au substrat par l'intermédiaire de deux poutres parallèles (52, 53), elles-mêmes reliées par deux entretoises (54, 55). Ces poutres parallèles (52, 53) ainsi que les entretoises (54, 55) sont dimensionnées de telle manière que la raideur mesurée selon les directions comprises dans le plan principal (42) du substrat soit extrêmement importantes. En revanche, la raideur mesurée perpendiculairement au plan principal (42) du substrat est ajustée selon une valeur appropriée. La présence des entretoises (54, 55) reliant les deux poutres (52, 53) augmente très fortement la raideur en torsion selon la direction des poutres (52, 53).

Du côté opposé, le plot (50) en matériau ferromagnétique comporte également deux poutres (58, 59) le reliant à une plaque métallique plane (47). Cette plaque métallique (47) forme l'armature mobile d'un condensateur variable dont l'armature fixe est constituée par une portion d'une piste plane (46) intégrée dans le substrat (42).

Le fonctionnement du dispositif est le suivant: lorsqu'un courant parcourt le bobinage métallique (43), un champ magnétique illustré par la flèche B₂ est généré. Ce champ magnétique est dirigé perpendiculairement au plan de l'enroulement (43) et donc du substrat. En fonction de l'intensité du courant lui donnant naissance, ce champ magnétique est d'amplitude variable. Il exerce sur le plot (50) en matériau ferromagnétique une force dirigée perpendiculairement au substrat (42), ce qui provoque la déformation des poutres (52, 53) reliant le plot (50) au point fixe (51).

Cette oscillation est transmise à l'armature mobile (47) du condensateur par l'intermédiaire des poutres (58, 59). La distance entre l'armature mobile (47) et l'armature fixe (46) variant, il s'ensuit que la capacité mesurée entre ces deux armatures varie également. Cette capacité peut être mesurée par un dispositif approprié via les poutres (52,53,58,59) et le plot (50), ou bien encore jouer un rôle dans un circuit dans lequel le condensateur est incorporé.

Le dispositif décrit à la figure 3 peut être réversible, puisqu'il peut fonctionner en utilisant le condensateur formé par les armatures (46, 47) en tant qu'étage d'entrée, et le bobinage plan (43) en tant qu'étage de sortie. Plus précisément, lorsqu'une tension alternative, éventuellement combinée avec une tension de polarisation est appliquée entre l'armature fixe (46) et l'armature mobile (47), une force de nature électrostatique rapproche ou éloigne l'armature mobile (47) de l'armature fixe (46). Il s'ensuit que grâce à la flexibilité des poutres (52, 53) le plot (50) en matériau ferromagnétique se déplace selon une direction sensiblement perpendiculaire au plan du substrat (42).

Si le plot (50) est en matériau ferromagnétique dur, une force contre électromotrice est générée entre les bornes (60, 61) de l'enroulement métallique (43), du fait de la variation de flux du champ magnétique généré par le plot (50).

Si le plot (50) est en matériau magnétique doux, son déplacement provoque une modification du circuit magnétique de l'enroulement plan (43), et donc une variation du coefficient d'inductance de ce dernier. C'est cette variation d'inductance qui peut être utilisée par ailleurs, soit par un dispositif prévu à cet effet, soit à l'intérieur d'un circuit incorporant ce bobinage, pour former par exemple un filtre multipolaire.

Il ressort de ce qui précède que les composants conformes à l'invention présentent de multiples avantages, et notamment celui de conserver une bonne amplitude de déplacement de l'équipage mobile, même dans les fréquences élevées de la gamme employée, ce qui permet d'obtenir un signal de sortie d'amplitude suffisante pour une exploitation satisfaisante.

## Revendications

1. Composant microélectromécanique (1) assurant des fonctions de filtrage, réalisé sur un substrat à base de matériau semi-conducteur, et comportant deux bornes d'entrée (8, 9) et deux bornes de sortie (30, 31), **caractérisé en ce qu'**il comporte également :
◆ un équipage mobile (4) relié au substrat par au moins une portion déformable (23, 24), et incluant une région (20) réalisée en un matériau ferromagnétique ;
◆ un bobinage métallique (5) relié aux bornes d'entrée ou de sortie (30, 31), apte à interagir magnétiquement avec la région (20) en matériau ferromagnétique de l'équipage mobile (4) ;
◆ une surface formant une première électrode (6), reliée à une des bornes de sortie ou d'entrée (8), disposée en regard d'une surface complémentaire (7) solidaire de l'équipage mobile (4), cette surface complémentaire (7) formant une seconde électrode reliée à l'autre (9) des bornes de sortie ou d'entrée, et étant apte à interagir électrostatiquement avec la première électrode (6).

2. Composant selon la revendication 1, **caractérisé en ce que** le bobinage métallique (5) est de type solénoïde.

3. Composant selon la revendication 1, **caractérisé en ce que** le bobinage métallique (43) est de type bobinage plan en spirale.

4. Composant selon la revendication 1, **caractérisé en ce que** l'équipage mobile (44) est relié au substrat par une seule portion déformable (52, 53).

5. Composant selon la revendication 1, **caractérisé en ce que** l'équipage mobile (4) est relié au substrat par deux portions déformables (23, 24) situées de part et d'autre de l'équipage mobile.

6. Composant selon la revendication 1, **caractérisé en ce que** le bobinage métallique (43) est relié aux bornes d'entrée (60, 61), et est apte à générer un champ magnétique B₂ lorsqu'il est parcouru par un courant, et **en ce que** l'équipage mobile (44) est apte à se déplacer sous l'effet de la force subie par la région (50) en matériau ferromagnétique, engendrée par le champ magnétique généré par le bobinage métallique (43), ce déplacement engendrant une variation de la capacité mesurée entre les deux électrodes (46, 47) reliées aux bornes de sortie.

7. Composant selon la revendication 1, **caractérisé en ce que** les électrodes (6, 7) sont reliées aux bornes d'entrée (8, 9), et sont aptes à se déplacer l'une par rapport à l'autre lorsqu'une différence de potentiel leur est appliquée, ce déplacement engendrant un déplacement de la région (20) en matériau ferromagnétique de l'équipage mobile par rapport au bobinage métallique (5).

8. Composant selon la revendication 1, **caractérisé en ce que** l'équipage mobile comporte une région en matériau ferromagnétique doux.

9. Composant selon la revendication 1, **caractérisé en ce que** l'équipage mobile comporte une région en matériau ferromagnétique dur, formant aimant permanent.
